# EUROPÄISCHE PATENTSCHRIFT

(11) **EP 0 732 810 B1**
(45) Veröffentlichungstag und Bekanntmachung des Hinweises auf die Patenterteilung: **25.04.2001**
(21) Anmeldenummer: 96102104.5
(22) Anmeldetag: 13.02.1996
(51) Int. Cl.: H03K 17/56, H03K 17/082

(54) **Steuerbahrer Halbleiterschalter**
Controllable semiconductor switch
Commutateur semi-conducteur commandable

(30) Priorität: 13.03.1995 DE 19509024
(43) Veröffentlichungstag der Anmeldung: 18.09.1996
(73) Patentinhaber: SGS-THOMSON MICROELECTRONICS GMBH, 85630 Grasbrunn (DE)
(72) Erfinder: Udo, John, 85586 Poing (DE)
(74) Vertreter: Klunker . Schmitt-Nilson . Hirsch

(56) Entgegenhaltungen:
- EP-A- 0 349 836
- EP-A- 0 360 991
- EP-A- 0 495 142
- US-A- 4 429 339
- IBM TECHNICAL DISCLOSURE BULLETIN, Bd. 29, Nr. 2, Juli 1986, ARMONNK, US, Seiten 567-569, XP002023190 "Reverse Bias Over-Current Protection for Power Field-Effect Transistors"

## Beschreibung

Die Erfindung betrifft eine integrierte Halbleiterschaltung mit einer steuerbaren Halbleiterschaltereinrichtung. Zusätzlich zu der Halbleiterschaltereinrichtung weist die integrierte Halbleiterschaltung üblicherweise eine Anzahl weiterer integrierter Schaltungskomponenten auf, welche eine Steuerschaltung bilden.

Transistoren, die für solche Halbleiterschaltereinrichtungen üblicherweise verwendet werden, beispielsweise PNP-Transistoren oder VDMOS-Transistoren, weisen Halbleiterübergänge unterschiedlichen Leitfähigkeitstyps auf, die zur Bildung parasitärer Elemente wie Dioden und Transistoren führen, die unter bestimmten Betriebsbedingungen der Halbleiterschaltung in einen leitenden Zustand gelangen können, der zu fehlerhaftem Verhalten der Halbleiterschaltung führen kann.

Prinzipiell ist es bekannt, Maßnahmen gegen unerwünschte Auswirkungen von parasitären Effekten bei integrierten Halbleiterschaltungen zu ergreifen. Aus der EP 0 409 158 A1 ist eine integrierte elektronische Halbleiterschaltereinrichtung bekannt, mittels welcher Lasten wie beispielsweise Anzeigelampen von Kraftfahrzeugen ein- und ausschaltbar sind. Das eigentliche Schalterelement dieser Halbleiterschaltereinrichtung bildet ein Bipolartransistor, dessen Kollektor mit der zu schaltenden Last verbunden ist. Zwischen dem Kollektor dieses Bipolartransistors und dem Substrat der integrierten Schaltung bildet sich eine parasitäre Diode, die in einen leitenden Zustand gelangen kann, wenn an dem nicht mit dem Bipolartransistor verbundenen Anschluß der zu schaltenden Last nicht, wie vorgesehen, das positive Potential der Fahrzeugbatterie liegt sondern deren negatives Potential, beispielsweise infolge falscher Polung der Batterie. Ein solches Leiten der parasitären Diode kann nicht nur zu einem falschen elektrischen Verhalten der Schaltereinrichtung führen sondern auch zu einer Schädigung der integrierten Halbleiterschaltung.

Als Schutz dagegen sieht die bekannte Schaltereinrichtung einen Komparator vor, dessen einer Eingang mit dem Kollektor des Bipolartransistors, dessen anderer Eingang mit einer Referenzpotentialquelle und dessen Ausgang mit der Basis des Bipolartransistors verbunden ist, der außerdem ein Schaltsteuersignal für den Bipolartransistor zugeführt wird. Sinkt das an der Last liegende Potential und damit die Kollektorspannung des Bipolartransistors relativ zu dem Referenzpotential zu weit ab, wird der Bipolartransistor über ein Ausgangssignal des Komparators in einen invers leitenden Zustand gebracht. Durch die dabei am Kollektor des Bipolartransistors auftretende Sättigungsspannung wird der Kollektor auf ein Potential gelegt, welches die parasitäre Diode vor einem Zustand unerwünschten Leitens schützt.

Bei einer Halbleiterschaltereinrichtung der eingangs genannten Art, mittels welcher ein Ausgangsanschluß dieser Halbleiterschaltung auf niedriges oder hohes Potential geschaltet wird, können sich die dort auftretenden parasitären Effekte dahingehend auswirken, daß die jeweils gewünschten Potentiale am Ausgangsanschluß nicht erreicht werden.

Derartige Ausgangsanschlüsse von Halbleiterschaltungen werden beispielsweise mit Busleitungen verbunden, über welche eine Mehrzahl solcher oder ähnlicher integrierter Halbleiterschaltungen miteinander verbunden ist. Entsprechend den über die Busleitung geschickten Datenimpulsen soll der Ausgangsanschluß einer bestimmten Halbleiterschaltung zu einem bestimmten Zeitpunkt ein dem Logikwert "1" entsprechendes erstes, beispielsweise hohes Potential oder ein dem Logikwert "0" entsprechendes zweites, beispielsweise niedriges Potential aufweisen. Bei dem niedrigen Potential handelt es sich üblicherweise um das Massepotential. Wenn nun beispielsweise bei der betrachteten Halbleiterschaltung die Verbindung zwischen dem Masseanschluß der Halbleiterschaltung und dem externen Bezugs- oder Massepotential unterbrochen wird, kann dies bewirken, daß der parasitäre Transistor des mit dem Ausgangsanschluß verbundenen Schalttransistors leitend wird und auf diese Weise ein beträchtlich über dem externen Massepotential liegendes positives Potential auf den Ausgangsanschluß geschaltet wird. Die Busleitung kann dann nicht mehr das korrekte niedrige Potential annehmen und es kann zur Datenverfälschung und Funktionsstörung des die fehlerhaft angeschlossene Halbleiterschaltung enthaltenden Gesamtsystems kommen.

Verschiedene Halbleiterschaltungen, deren Ausgangsanschlüsse an eine gemeinsame Busleitung angeschlossen sind, sind mit ihren Masseanschlüssen üblicherweise an eine gemeinsame Masseleitung angeschlossen. Aufgrund des räumlichen Abstandes unterschiedlicher integrierter Halbleiterschaltungen des Gesamtsystems, der beispielsweise im Bereich der Kraftfahrzeugelektronik recht groß sein kann, kann sich zwischen den Masseanschlüssen der verschiedenen integrierten Halbleiterschaltungen ein erheblicher Leitungswiderstand mit entsprechendem Spannungsabfall bemerkbar machen, der zu beträchtlichen Unterschieden in den Massepotentialen der verschiedenen integrierten Halbleiterschaltungen führen kann. Als Folge davon kann der Ausgangsanschluß einer bestimmten integrierten Halbleiterschaltung von einer anderen integrierten Halbleiterschaltung über den Leitungsbus mit einem Massepotential beaufschlagt werden, das um einiges niedriger ist als das Massepotential der betrachteten bestimmten Halbleiterschaltung. Auch in diesem Fall kann der parasitäre Transistor des mit dem Ausgangsanschluß verbundenen Schalttransistors in den leitenden Zustand gelangen und den Ausgangsanschluß und damit die Busleitung auf ein Massepotential bringen, das für andere mit der Busleitung verbundene integrierte Halbleiterschaltungen zu hoch ist.

Man hat bereits versucht, diesem Problem dadurch zu entgegnen, daß man zwischen den Ausgangsanschluß und den Schalttransistor der integrierten Halbleiterschaltung eine Sperrdiode in Reihe schaltet, die dann sperrt, wenn der Ausgangsanschluß bezüglich des Massepotentials der integrierten Halbleiterschaltung zu niedriges Potential annimmt. Wird der parasitäre Transistor der Halbleiterschaltereinrichtung aufgrund dieses zu niedrigen Potentials am Ausgangsanschluß leitend geschaltet, obwohl die Halbleiterschaltereinrichtung selbst nicht leitet, wird ein über den Ausgangsanschluß führender Stromfluß durch den parasitären Transistor gesperrt.

Diese Lösung hat jedoch den Nachteil, daß zwischen dem Ausgangsanschluß und der Halbleiterschaltereinrichtung immer mindestens ein der Diodeneinschaltspannung entsprechender Spannungsabfall vorhanden ist.

Als Folge davon kann bei leitend geschalteter Halbleiterschaltereinrichtung das Potential am Ausgangsanschluß nicht so niedrig wie gewünscht eingestellt werden, beispielsweise nicht unter 1 V liegen. Es ist aber erwünscht, das niedrige Potential am Ausgangsanschluß so niedrig wie möglich zu machen, um einen möglichst großen Signal/Rausch-Abstand zu erhalten.

Zur Überwindung des aus der Verwendung der Sperrdiode resultierenden Problems ist es aus der EP-A-0 360 991 bekannt, die Sperrdiode durch eine zweite Halbleiterschaltereinrichtung zu ersetzen, wobei die beiden Halbleiterschaltereinrichtungen durch zwei in Reihenschaltung angeordnete DMOS-Leistungstransistoren gebildet sind, deren Drainanschlüsse miteinander verbunden sind.

Mit der vorliegenden Erfindung soll eine integrierte Halbleiterschaltung verfügbar gemacht werden, bei welcher ein wirksamer Schutz gegen parasitäre Effekte der erläuterten Art vorhanden ist.

Dies wird erfindungsgemäß erreicht mit einer integrierten Halbleiterschaltung der im Patentanspruch 1 angegebenen Art, die gemäß den abhängigen Patentansprüchen weitergebildet werden kann.

Das Prinzip der vorliegenden Erfindung besteht darin, daß - in aus der EP-A-0 360 991 an sich bekannten Art - eine zweite Halbleiterschaltereinrichtung in Reihenschaltung mit einer ersten Halbleiterschaltereinrichtung geschaltet wird, jedoch mit einer Polung der Anschlüsse, die der Polung der Anschlüsse der ersten Halbleiterschaltereinrichtung entgegengesetzt ist. Zwischen den mit dem Ausgangsanschluß verbundenen Hauptstreckenanschluß der zweiten Halbleiterschaltereinrichtung und deren Steueranschluß ist ein elektrischer Widerstand geschaltet. Bei einem vorbestimmten Mindeststrom durch diesen Widerstand entsteht über dem Widerstand ein Spannungsabfall, der zum Leitendschalten der zweiten Halbleiterschaltereinrichtung führt. Dadurch, daß die zweite Halbleiterschaltereinrichtung mit einer zur Polung der ersten Halbleiterschaltereinrichtung entgegengesetzten Polung in Reihe zur ersten Halbleiterschaltereinrichtung geschaltet ist, wirkt sich der parasitäre Transistor der zweiten Halbleiterschaltereinrichtung nicht auf das Potential am Ausgangsanschluß der Halbleiterschaltung aus. Eine Steuerschaltung, die einen mit dem gemeinsamen Schaltungspunkt gekoppelten Signaleingang und einen mit dem elektrischen Widerstand gekoppelten Signalausgang aufweist, sorgt dafür, daß der Widerstand dann von ausreichendem Strom durchflossen wird, um die zweite Halbleiterschaltereinrichtung einzuschalten, wenn die erste Halbleiterschaltung leitend geschaltet ist. Ist die Halbleiterschaltung defekt, fließt auch kein Strom durch den Widerstand, so daß die zweite Halbleiterschaltereinrichtung auf jeden Fall nicht-leitend geschaltet bleibt. Mittels einer Schwellenwertdetektorschaltung wird bei funktionierender integrierter Halbleiterschaltung permanent überwacht, ob das Potential am Ausgangsanschluß in einen Bereich gelangt, bei welchem die parasitären Transistoren der beiden Halbleiterschaltereinrichtungen in den leitenden Zustand gelangen. Sobald die Schwellenwertdetektorschaltung einen solchen Potentialwert am Ausgangsanschluß detektiert, bewirkt sie, daß durch den Widerstand nicht mehr der Mindeststrom zum Leitendschalten der zweiten Halbleiterschaltereinrichtung fließen kann, so daß die zweite Halbleiterschaltereinrichtung nicht-leitend geschaltet wird.

Durch die erfindungsgemäßen Maßnahmen wird also sichergestellt, daß sich parasitäre Effekte der mit dem Ausgangsanschluß in Reihe geschalteten Halbleiterschaltereinrichtungen nicht auf das Potential am Ausgangsanschluß auswirken können und daß das niedrigste Potential, das bei leitendgeschalteter erster Halbleiterschaltereinrichtung auf den Ausgangsanschluß geschaltet werden kann, nicht durch einen Diodenspannungsabfall erhöht wird, wie er bei herkömmlichen Schutzschaltungen auftritt.

Vorteilhafte Weiterbildungen der Erfindung sind in den abhängigen Ansprüchen angegeben.

Die Erfindung wird nun anhand einer Ausführungsform näher erläutert. In den Zeichnungen zeigen:
**Fig. 1** ein schematisches Schaltbild einer Ausführungsform einer erfindungsgemäßen integrierten Halbleiterschaltung;
**Fig. 2** eine schematische Darstellung eines Teils einer herkömmlichen Schaltung; und
**Fig. 3** eine Darstellung zur Erläuterung von parasitären Effekten bei integrierten Halbleiterschaltungen.

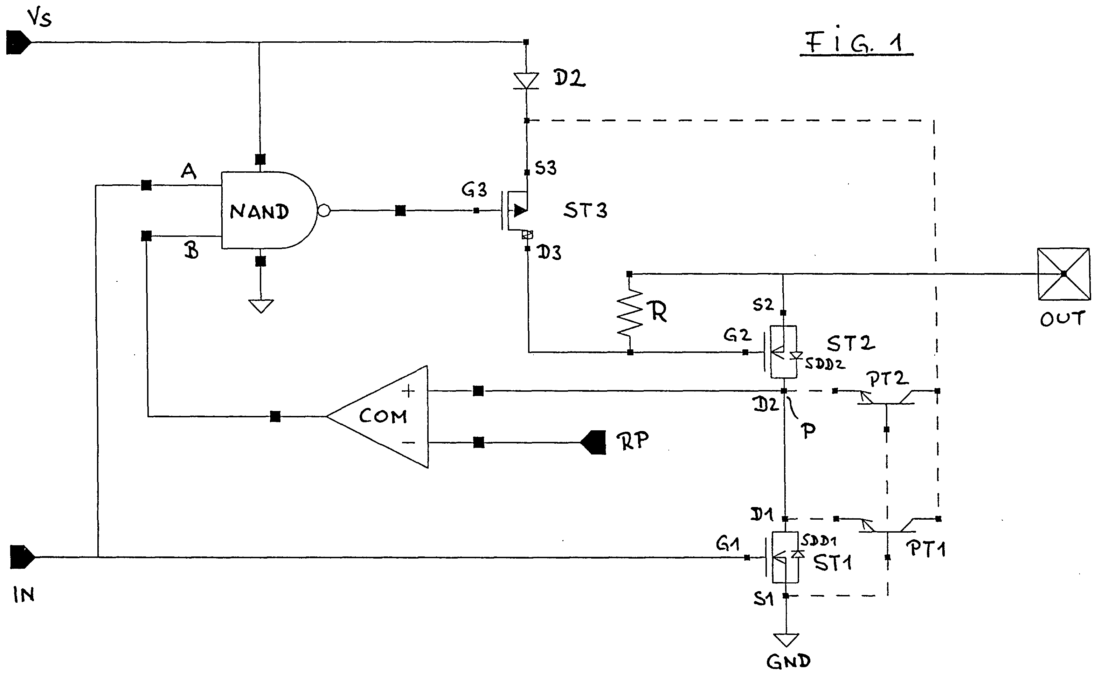

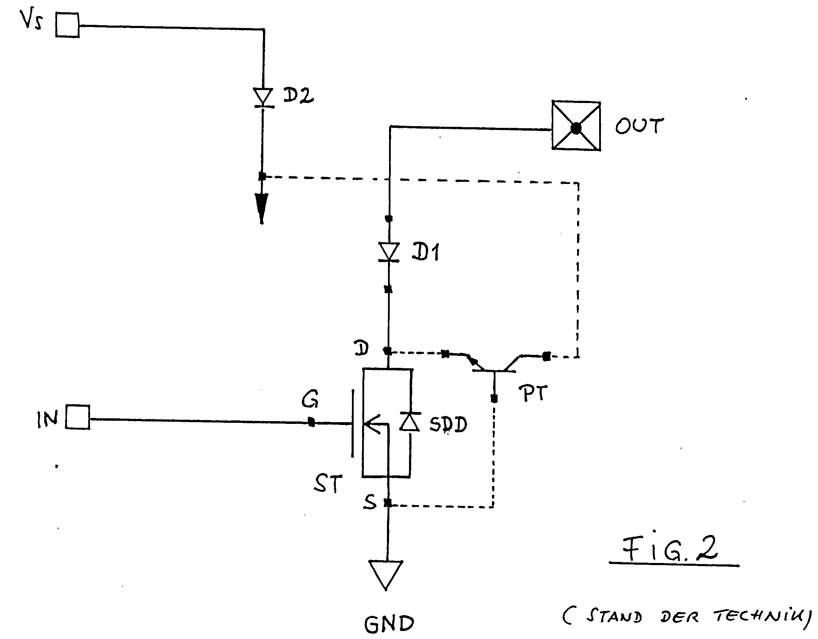

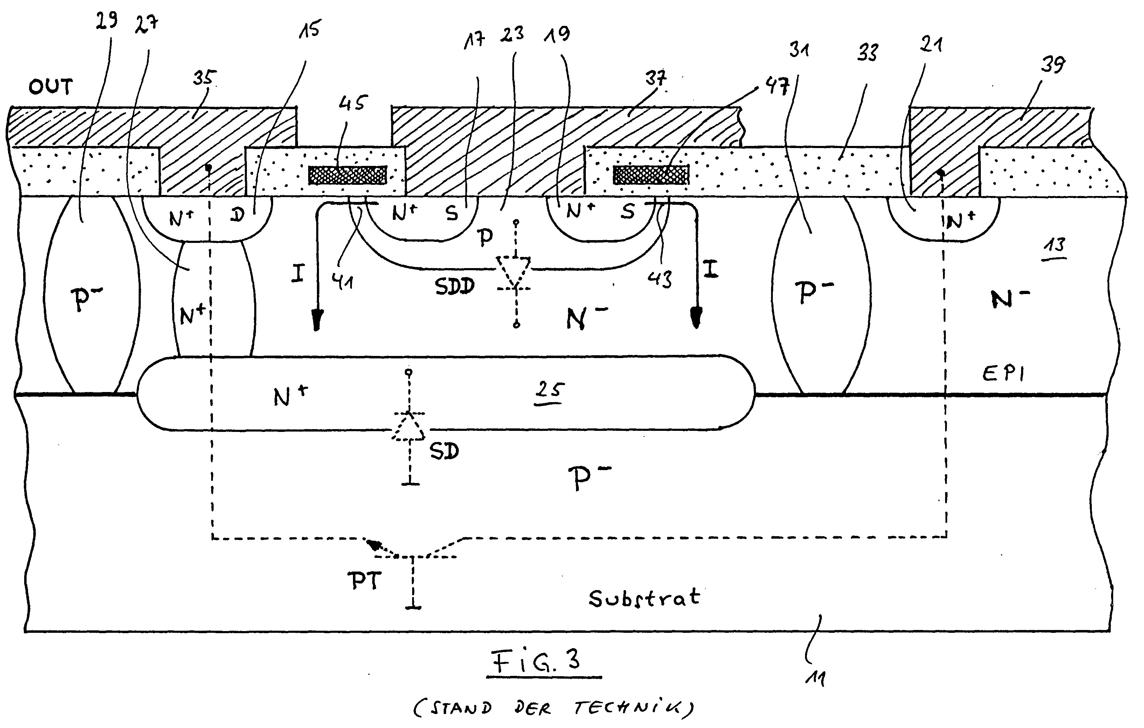

Bevor die in Figur 1 gezeigte Ausführungsform der Erfindung näher erläutert wird, werden anhand der Figuren 2 und 3 die mit der Erfindung überwundenen Probleme betrachtet.

Figur 2 zeigt in schematischer Schaltbilddarstellung einen Ausschnitt aus einer integrierten Halbleiterschaltung mit einem Versorgungsspannungsanschluß Vs für die Versorgung mit einem Versorgungsspannungspotential, einem Eingangsanschluß IN für ein Steuersignal und einem Ausgangsanschluß OUT, der für den Anschluß an eine nicht dargestellte Busleitung vorgesehen ist. Außerdem weist diese Schaltung einen Masseanschluß GND für die Versorgung mit Massepotential auf. Zwischen OUT und GND ist eine Reihenschaltung aus einem Schalttransistor ST auf der Masseanschlußseite und einer ersten Diode D1 auf der Ausgangsanschlußseite vorgesehen. An den Versorgungsspannungsanschluß Vs ist eine Versorgungsspannungsleitung angeschlossen, die eine zweite Diode D2 aufweist und mit einer in Figur 2 nicht näher dargestellten Schaltungsanordnung der integrierten Halbleiterschaltung verbunden ist.

Bei dem Schalttransistor ST handelt es sich bei dem dargestellten Schaltungsbeispiel um einen vertikalen doppelt diffundierten MOS-Transistor, der nach der englischen Bezeichnung "Vertical Double-Diffused MOS" auch abgekürzt mit VDMOS-Transistor bezeichnet wird.

Mittels eines über den Eingangsanschluß IN zugeführten Steuersignals wird der Schalttransistor ST entweder leitend oder nicht-leitend geschaltet, so daß am Ausgangsanschluß OUT entweder Massepotential oder ein im Bereich des Versorgungsspannungspotentials oder eines Bruchteils davon liegendes Potential erscheint.

Der Schalttransistor ST weist einen zum Ausgangsanschluß OUT weisenden Drain-Anschluß D, einen zum Masseanschluß GND weisenden Source-Anschluß S und einen zum Eingangsanschluß IN weisenden GateAnschluß G auf. Bei der in Figur 2 gezeigten Schaltung weist die an Vs anliegende Versorgungsspannung ein positives Potential gegenüber dem Masseanschluß GND auf.

Figur 3 zeigt in Ausschnittsdarstellung eine schematische, nicht maßstabsgetreue Schnittansicht einer integrierten Halbleiterschaltung mit einem VDMOS-Transistor. Auf einem Substrat 11 mit P⁻-Leitfähigkeit befindet sich eine epitaktische Schicht 13 mit N⁻-Leitfähigkeit. In deren vom Substrat 11 abliegende Oberfläche sind vier Zonen mit N⁺-Leitfähigkeit diffundiert, nämlich eine Drainzone 15, Sourcezonen 17, 19 und eine Zone 21. Die Sourcezonen 17 und 19 sind in eine Diffusionszone 23 mit P-Leitfähigkeit eingebettet. Im Übergangsbereich zwischen Substrat 11 und epitaktischer Schicht 13 befindet sich eine vergrabene Schicht 25 mit N⁺-Leitfähigkeit. Die Drainzone 15 und die vergrabene Schicht 25 sind mit einer N⁺-Leitfähigkeit aufweisenden Zwischendiffusionszone 27 miteinander verbunden. Beidseits der vergrabenen Schicht 25 befindet sich je eine Isolierdiffusion 29 bzw. 31 mit P⁻-Leitfähigkeit. Die vom Substrat 11 abliegende Oberfläche der epitaktischen Schicht 13 ist mit einer Isolierschicht 33 bedeckt, die mit Öffnungen für eine die Drainzone 15 kontaktierende Drainelektrode 35, eine die Sourcezonen 17 und 19 sowie die Diffusionszone 23 kontaktierende Sourceelektrode 37 und eine die weitere N⁺-Zone 21 kontaktierende weitere Elektrode 39 versehen ist. In dem an die Isolierschicht 33 angrenzenden Oberflächenbereich der epitaktischen Schicht 13 befindet sich zwischen den Sourcezonen 17 und 19 und dem außerhalb der Diffusionszone 23 befindlichen Bereich der epitaktischen Schicht 13 nur ein schmaler lateraler Bereich 41 bzw. 43 der Diffusionszone 23. Oberhalb dieser lateralen Bereiche 41 und 43 befindet sich je eine Gateelektrode 45 bzw. 47, die mittels der Isolierschicht 33 von der Oberfläche der epitaktischen Schicht 13 isoliert ist. Beim Anlegen einer geeigneten Source-Gate-Spannung erzeugt das an den Gateelektroden 45, 47 liegende Potential eine Inversionsschicht im Oberflächenbereich der lateralen Bereiche 41 und 43, die einen durch die Strompfeile I angedeuteten Stromfluß von den Sourcezonen 17, 19 durch die lateralen Bereiche 41, 43 hindurch zur vergrabenen Schicht 25 und damit zur Drainelektrode 35 ermöglicht. Der PN-Halbleiterübergang zwischen der Diffusionszone 23 und der epitaktischen Schicht 13 bildet eine in Figur 3 gestrichelt angedeutete Source-Drain-Diode SDD. Zwischen der vergrabenen Schicht 25 und dem Substrat 11 bildet sich eine ebenfalls gestrichelt angedeutete Substratdiode SD. Die Substratdiode SD leitet dann, wenn sich die Drainelektrode 35 auf einem Potential befindet, das um mindestens die Einschaltschwellenspannung der Substratdiode SD niedriger ist als das am Substrat 11 liegende Potential.

Befindet sich außerhalb der Isolierdiffusionen 29 und 31 des VDMOS-Transistors eine mit einer Elektrode kontaktierte N-Diffusionszone, wie die N⁺-Zone 21 mit der Elektrode 39, wird die Substratdiode SD Teil eines parasitären NPN-Transistors, der in Figur 3 gestrichelt dargestellt und mit PT bezeichnet ist. Den Emitter von PT bildet die Drainzone 15, den Kollektor bildet die weitere Zone 21 und das Substrat 11 fungiert als Basis des parasitären Transistors PT.

Befindet sich der Ausgangsanschluß OUT und somit die Drainelektrode 35 auf einem Potential, das soweit unterhalb des Substratpotentials liegt, daß die Substratdiode SD leitet, leitet dieser parasitäre Transistor PT, so daß das Potential der weiteren Elektrode 39 auf den Ausgangsanschluß OUT durchgeschaltet wird. Der Ausgangsanschluß OUT kann daher das Potential, auf dem er sich befinden sollte, nicht halten.

Weitere Angaben zu DMOS-Feldeffekttransistoren und zu parasitären Effekten befinden sich in dem Buch "Power Integrated Circuits: Physics, Design and Applications" von Paolo Antognetti, MacGraw-Hill Book Company, Seiten 3.8 bis 3.13 und 4.19 bis 4.21.

Es wird nun wieder Figur 2 betrachtet. Diese zeigt außer den bereits zuvor beschriebenen Schaltungskomponenten mit gestrichtelten Anschlüssen den im Zusammenhang mit Figur 3 erläuterten parasitären Transistor PT mit der durch die Substratdiode gebildeten Basis-Emitter-Strecke und mit Kollektorzugriff zu einer kathodenseitigen N-Diffusionszone der Diode D2. Geht man zunächst davon aus, daß der Ausgangsanschluß OUT mit dem Drainanschluß des Schalttransistors ST nicht über die Diode D1 sondern direkt verbunden ist, leitet der parasitäre Transistor PT, wenn sich der Ausgangsanschluß OUT auf einem Potential befindet, das um mindestens die Durchlaßschwellenspannung der Substratdiode SD negativer ist als das am Masseanschluß GND anliegende Massepotential. Als Folge davon wird das im Fall des Leitens der Diode D2 im Bereich des Potentials des Versorgungsspannungsanschlusses Vs liegende kathodenseitige Potential der Diode D2 über den parasitären Transistor PT auf den Drainanschluß D des Schalttransistors ST und damit auf den Ausgangsanschluß OUT durchgeschaltet. Der mit OUT verbundene Leitungsbus kann dann nicht mehr auf das gewünschte niedrige Potential gebracht werden, was eine Störung für andere an den Bus angeschlossene integrierte Schaltungen, möglicherweise für das Gesamtsystem, nach sich zieht.

Gemäß dem bereits genannten Vorschlag ist zwischen OUT und ST die Diode D1 angeordnet. Diese sperrt, wenn das Potential von OUT zu niedrig wird, und verhindert dann einen Stromfluß durch PT, so daß dieser ein an seinem Kollektor anliegendes positives Potential nicht zum Ausgangsanschluß OUT durchschalten kann.

Dies hat den bereits erwähnten Nachteil, daß zwischen OUT und dem Drainanschluß von ST ein der Durchschaltschwelle der Diode D1 entsprechender Spannungsabfall liegt, wenn ST leitend geschaltet ist. Dies hat zur Folge, daß das Potential am Ausgangsanschluß OUT nicht unter 1 V gehen kann. Da verschiedene integrierte Schaltungen, wenn sie sich in einem größeren Abstand voneinander befinden, aufgrund des bereits erwähnten Masseleitungswiderstandes unterschiedliche Massenpotentiale haben können, die sich möglicherweise bis etwa 2 V voneinander unterscheiden, ist die durch den Spannungsabfall über der Diode D1 verursachte zusätzliche Potentialerhöhung an OUT zu hoch, um einen ausreichend sicheren Signal/Rausch-Abstand auf der an OUT angeschlossenen Busleitung zu erreichen.

Mit der in Figur 1 gezeigten, eine bevorzugte Ausführungsform der Erfindung darstellenden Schaltungsanordnung werden die geschilderten Probleme überwunden.

Bei der in Figur 1 gezeigten Ausführungsform der Erfindung befindet sich zwischen dem Ausgangsanschluß OUT und dem Masseanschluß GND eine Reihenschaltung aus einem masseanschlußseitigen ersten Schalttransistor ST1 und einem ausgangsanschlußseitigen zweiten Schalttransistor ST2. Die beiden Transistoren ST1 und ST2 sind je durch einen VDMOS-Transistor gebildet. Dabei ist ST2 mit einer Polung seiner Anschlüsse in diese Reihenschaltung eingefügt, die der Polung der Anschlüsse von ST1 entgegengesetzt ist. Daher sind die Drainanschlüsse D1 und D2 der beiden Schalttransistoren ST1 und ST2 miteinander verbunden, ist der Sourceanschluß S1 von ST1 mit GND und ist der Sourceanschluß S2 von ST2 mit OUT verbunden. Der Gateanschluß G1 ist mit einem Eingangsanschluß IN verbunden, über den Schaltsteuersignale für ST1 zugeführt werden. Zwischen den Gateanschluß G2 und den Sourceanschluß S2 von ST2 ist ein Widerstand R geschaltet. Dessen Widerstandswert ist so bemessen, daß bei einem Mindeststromfluß durch R an diesem Widerstand ein Spannungsabfall entsteht, der die Source-Gate-Einschaltschwellenspannung von ST2 übersteigt, die bei praktischen Ausführungsformen von ST2 bei etwa 1,5 V liegt. Für beide Schalttransistoren ST1 und ST2 ist deren inhärente Source-Drain-Diode SDD1 bzw. SDD2 dargestellt, die wie eine dem VDMOS-Transistor parallel geschaltete Diode wirkt. Aufgrund der gewählten Polung der Anschlüsse von ST2 weist SDD2 die gleiche Polung auf wie die Diode D1 in Figur 2.

Beide Schalttransistoren ST1 und ST2 weisen einen parasitären Transistor PT1 bzw. PT2 auf, wie er im Zusammenhang mit den Figuren 2 und 3 betrachtet worden ist. Aufgrund der zur Polung von ST1 entgegengesetzten Polung von ST2 wirkt sich ein Potential, das von der Kollektorseite des parasitären Transistors PT2 auf den Drainanschluß D2 von ST2 durchgeschaltet wird, nicht auf das Potential des Ausgangsanschlusses OUT aus.

Die in Figur 1 gezeigte Schaltung weist außerdem einen Komparator COM auf, dessen nicht-invertierender Eingang mit dem den beiden Drainanschlüssen D1 und D2 gemeinsamen Schaltungspunkt P und dessen invertierender Eingang mit einer Referenzpotentialquelle RP verbunden ist. Die Schaltungsanordnung nach Figur 1 umfaßt ferner eine NAND-Verknüpfüngsschaltung, deren einer Eingang A mit dem Eingangsanschluß IN und deren anderer Eingang B mit dem Ausgang des Komparators COM verbunden sind. Der Ausgang von NAND ist mit einem Gateanschluß G3 eines als MOS-Transistor ausgebildeten Schalttransistors ST3 verbunden, dessen Drainanschluß D3 mit dem Gateanschluß G2 von ST2 verbunden ist. Der Sourceanschluß S3 von ST3 ist über eine Diode D2 mit dem Versorgungspannungsanschluß Vs verbunden.

Der Komparator COM liefert an seinem Ausgang dann, wenn das an den Drainanschlüssen D1 und D2 liegende Potential niedriger wird als das Referenzpotential RP ein diesen Zustand anzeigendes Ausgangssignal. Das heißt, wenn das Potential am Ausgangsanschluß OUT niedriger als ein vorbestimmter Potentialwert wird, liefert der Komparator COM ein solches Ausgangssignal.

Der Widerstandswert des Widerstandes R ist so gewählt, daß bei leitend geschaltetem Schalttransistor ST3 ein Strom durch R fließt, der über R einen solchen Spannungsabfall zur Folge hat, daß der Schalttransistor ST2 leitend geschaltet wird.

Der Komparator COM, die NAND-Verknüpfungsschaltung und der Schalttransistor ST3 bilden eine Steuerschaltung, wobei der nicht-invertierende Eingang + des Komparators COM einen Signaleingang und der Drainanschluß des Schalttransistors ST3 einen Signalausgang bilden. Somit ist der Signaleingang der Steuerschaltung mit dem Schaltungspunkt P verbunden und ist deren Signalausgang mit dem Widerstand R verbunden.

Es wird nun die Funktionsweise der in Figur 1 gezeigten Schaltung betrachtet. Dabei wird davon ausgegangen, daß sich der Masseanschluß GND auf 0 V befinden soll, während am Versorgungsspannungsanschluß Vs ein gegenüber dem Massepotential positives Potential anliegt.

Liegt am Eingangsanschluß IN ein Steuersignal mit dem Logikwert "0" an, ist ST1 nicht-leitend geschaltet. Außerdem führt dies zu einem Logikwert "1" am Ausgang von NAND, so daß ST3 nicht-leitend geschaltet ist. Folglich wird über den Widerstand R kein Strom geliefert und bleibt auch ST2 nicht-leitend. Aufgrund des Nichtleitens von ST1 und ST2 wird das am Masseanschluß GND befindliche Potential nicht auf den Ausgangsanschluß OUT durchgeschaltet. Von den beiden Source-Drain-Dioden SDD1 und SDD2, die den Schalttransistoren ST1 bzw. ST2 inhärent sind, ist unabhängig vom Potential am Ausgangsanschluß OUT mindestens eine gesperrt. Ist das Ausgangsanschlußpotential an OUT gegenüber dem Massepotential an GND positiv, sperrt SDD1. Fällt das Ausgangsanschlußpotential unter einen solchen Wert, daß SDD1 leitet, sperrt SDD2. Mangels leitender Verbindung zwischen OUT und GND bestimmt sich das Ausgangspotential an OUT somit lediglich durch das von anderen Komponenten des Busleitungssystems über die Busleitung zugeführte Potential.

Für den Fall, daß dem Eingangsanschluß IN ein den Schalttransistor ST1 leitend schaltendes Logiksignal "1" mit hohem Potentialwert zugeführt wird, sei zunächst angenommen, daß am Ausgangsanschluß OUT ein Potential liegt, das am als Spannungsteilerpunkt dienenden Verbindungspunkt P zwischen den beiden Schalttransistoren ST1 und ST2 ein Potential hervorruft, das höher ist als das Referenzpotential RP. Unter dieser Bedingung liefert der Komparator COM als Ausgangssignal einen Logikwert "1". An den beiden Eingängen A und B von NAND liegt somit der Logikwert "1", so daß vom Ausgang von NAND ein Logikwert "0" auf den Schalttransistor ST3 gegeben wird. ST3 ist daher ebenfalls leitend geschaltet. Als Folge davon fließt über den Widerstand R ein Strom, der einen ausreichenden Spannungsabfall zur Folge hat, um den Schalttransistor ST2 ebenfalls leitend zu schalten. Somit ist die zwischen OUT und GND befindliche Reihenschaltung aus den beiden Schalttransistoren ST1 und ST2 leitend geschaltet und auf den Ausgangsanschluß OUT gelangt das am Masseanschluß GND anliegende Massepotential. Die den Schalttransistoren ST1 und ST2 inhärenten Source-Drain-Dioden SDD1 und SDD2, die aufgrund der bezüglich ST1 inversen Polung von ST2 mit entgegengesetzter Polung in Reihe geschaltet sind, werden je durch den leitend geschalteten Schalttransistor ST1 bzw. ST2 kurzgeschlossen und haben somit keine Wirkung.

Die Schutzwirkung der ST2, ST3 und R umfassenden Schutzschaltung wird nun anhand von drei Fällen betrachtet, gegen die Schutz erforderlich ist.
1. Funktionsausfall der betrachteten integrierten Halbleiterschaltung;
2. GND-Potentialausfall;
3. Ausgangsanschlußpotential ist zu niedrig bezüglich des Massepotentials der betrachteten Halbleiterschaltung.

### Zu Fall 1:

Ist die Funktion der betrachteten integrierten Halbleiterschaltung wesentlich gestört, ist ST3 nicht-leitend, so daß über den Widerstand R kein den Schalttransistor ST2 einschaltender Strom fließen kann. Die Verbindung zwischen OUT und GND bleibt daher gesperrt.

### Zu Fall 2:

Kommt es zu einem GND-Potentialausfall beispielsweise weil die Massezuleitung zu dem Masseanschluß der integrierten Halbleiterschaltung defekt ist, befindet sich das Massepotential der betrachteten integrierten Halbleiterschaltung im floatenden, also unbestimmten Zustand. Dies kann dazu führen, daß am Ausgangsanschluß OUT ein Potential liegt, das bezüglich des floatenden Massepotentials der betrachteten integrierten Halbleiterschaltung so niedrig ist, daß das Teilpotential am Verbindungspunkt P niedriger wird als das Referenzpotential RP. Am Ausgang des Komparators COM erscheint dann der Logikwert "0", was einen Logikwert "1" am Ausgang von NAND und damit ein Sperren von ST3 nach sich zieht. Dadurch wird der Stromfluß durch den Widerstand R unterbrochen, was ST2 in den nicht-leitenden Zustand bringt. Das positive Potential an der Kathodenseite D2 oder einer anderen Schaltungskomponente der integrierten Halbleiterschaltung, die eine N-leitende Zone umfaßt, die einen Kollektor für den parasitären Transistor PT2 bildet, kann auch dann, wenn die Substratdiode SD2 von ST2 und folglich der parasitäre Transistor PT2 leitet, aufgrund des Sperrens von ST2 nicht auf den Ausgangsanschluß OUT durchgeschaltet werden. Aufgrund der inversen Polung von ST2 kann dieses positive Potential auch nicht über dessen inhärente Source-Drain-Diode SDD2 auf OUT gelangen.

### Zu Fall 3:

Weist die betrachtete integrierte Halbleiterschaltung ein individuelles Massepotential auf, das höher ist als das individuelle Massepotential einer anderen intergrierten Halbleiterschaltung, die über eine Busleitung mit dem Ausgangsanschluß OUT der betrachteten integrierten Halbleiterschaltung verbunden ist, beispielsweise wegen des bereits erwähnten Spannungsabfalls an der zwei intergrierte Halbleiterschaltungen verbindenden Masseleitung, kann es ebenfalls dazu kommen, daß am Ausgangsanschluß ein Potential anliegt, das niedriger ist als das individuelle Massepotential am Masseanschluß GND der betrachteten integrierten Halbleiterschaltung. Auch in diesem Fall fällt das Teilpotential am Verbindungspunkt P unter den Wert des Referenzpotentials RP ab, mit der gleichen Folge wie im Fall 2: ST3 und damit ST2 werden abgeschaltet, SDD2 sperrt und weder das individuelle Massepotential am Anschluß GND noch ein über den parasitären Transistor PT1 und/oder den parasitären Transistor PT2 an die Drain-Anschlüsse D1 und D2 gelangendes positives Potential kann an den Ausgangsanschluß OUT gelangen.

Vorausgehend ist ein Ausführungsbeispiel betrachtet worden, bei welchem Schutz gegen parasitäre Effekte von VDMOS-Transistoren erreicht wird. Solche parasitären Effekte treten aber auch bei anderen Transistor-Typen auf, beispielsweise bipolaren NPN-Transistoren. Auch in diesem Fall bietet die erfindungsgemäße Schaltung Schutz.

Das Ausführungsbeispiel gemäß Figur 1 ist für den Fall betrachtet worden, daß das Versorgungsspannungspotential positiv gegenüber dem Massepotential der integrierten Halbleiterschaltung ist. Die erfindungsgemäße Schutzmaßnahme ist auch dann anwendbar, wenn umgekehrte Polung verwendet wird, also ein gegenüber Massepotential negatives Versorgungsspannungspotential. In diesem Fall kann man Schalttransistoren ST1 bis ST3 verwenden, deren Leitfähigkeitstypen zu den in Figur 1 vorgesehenen Schalttransistoren entgegengesetzt sind, wobei ST2 bezüglich ST1 mit inverser Polung geschaltet ist.

Hinsichtlich des Einsatzes der erfindungsgemäßen Schutzschaltung ist insbesondere an die Kraftfahrzeugelektronik zu denken. In den rauhen Umgebungsbedingungen, wie sie für die Kraftfahrzeugelektronik gelten, kann es besonders leicht zu Problemen wie GND- oder Masseunterbrechung kommen. Aufgrund der großen Abstände, welche an dem selben Busleitungssystem liegende integrierte Schaltungen haben können, ist auch im Bereich der Kraftfahrzeugelektronik das voneinander Abweichen der individuellen Massepotentiale der einzelnen voneinander entfernten integrierten Halbleiterschaltungen besonders schwerwiegend.

Die erfindungsgemäße Schaltung bewährt sich auch als EMI-Schutz (Schutz gegen elektromagnetische Störimpulse). Sowohl bei positiv gerichteten Störimpulsen, die sich auf das individuelle Massepotential der betrachteten integrierten Halbleiterschaltung auswirken, als auch bei negativen Störimpulsen, die von außen auf den Ausgangsanschluß OUT der betrachteten integrierten Halbleiterschaltung gelangen, wird die erfindungsgemäße Schutzabschaltung wirksam.

Schutz ist mit der erfindungsgemäßen Schaltung auch gegen den falsch gepolten Anschluß einer Batterie gegeben, bei welchem auf den Ausgangsanschluß OUT ein Potential gelangen kann, das wesentlich niedriger ist als das am Masseanschluß GND anliegende Potential.

## Patentansprüche

1. Integrierte Halbleiterschaltung, aufweisend:
a) einen Versorgungsspannungsanschluß (Vs), einen Masseanschluß (GND) zur Verbindung mit einem Bezugspotential und einen Ausgangsanschluß (OUT);
b) ein mit dem Masseanschluß (GND) verbundenes Substrat (11);
c) eine zwischen Ausgangsanschluß (OUT) und Masseanschluß (GND) befindliche Reihenschaltung mit einer auf der Masseanschlußseite befindlichen steuerbaren ersten Halbleiterschaltereinrichtung (ST1) und einer auf der Ausgangsanschlußseite befindlichen steuerbaren zweiten Halbleiterschaltereinrichtung (ST2), die je eine erste Hauptstreckenelektrode (D1, D2), eine zweite Hauptstreckenelektrode (S1, S2) und eine Steuerelektrode (G1, G2) aufweisen und je eine zwischen der ersten Hauptstreckenelektrode und dem Substrat liegende parasitäre Substratdiode (SD) enthalten;
d) wobei die ersten Hauptstreckenelektroden (D1, D2) der beiden Halbleiterschaltereinrichtungen (ST1,ST2) miteinander, die zweite Hauptstreckenelektrode (S1) der ersten Halbleiterschaltereinrichtung (ST1) mit dem Masseanschluß (GND) und die zweite Hauptstreckenelektrode (S2) der zweiten Halbleiterschaltereinrichtung (ST2) mit dem Ausgangsanschluß (OUT) gekoppelt sind;
e) ein die Steuerelektrode (G2) und die zweite Hauptstreckenelektrode (S2) der zweiten Halbleiterschaltereinrichtung (ST2) verbindender elektrischer Widerstand (R);
f) eine mit einem Steueranschluß (G3) versehene dritte Halbleiterschaltereinrichtung (ST3), deren Hauptstrecke (S-D) zwischen den Versorgungsspannungsanschluß (Vs) und den Steueranschluß (G2) der zweiten Halbleiterschaltereinrichtung (ST2) geschaltet ist und die im leitenden Schaltzustand durch den Widerstand (R) einen Strom leitet, der am Widerstand (R) einen die zweite Halbleiterschaltereinrichtung (ST2) leitend steuernden Spannungsabfall bewirkt;
g) eine Schwellenwertdetektorschaltung (COM), mittels welcher das Abfallen des Potentials am Verbindungspunkt (P) zwischen erster und zweiter Halbleiterschaltereinrichtung (ST1, ST2) auf ein Referenzpotential (RP) detektiert wird, und
h) eine zwischen die Schwellenwertdetektorschaltung (COM) und den Steueranschluß der dritten Halbleiterschaltereinrichtung (ST3) geschaltete Verknüpfungsschaltung (NAND), mittels welcher die dritte Halbleiterschaltereinrichtung (ST3) bei nicht-leitend geschalteter erster Halbleiterschaltereinrichtung (ST1) und bei leitend geschalteter erster Halbleiterschaltereinrichtung (ST1) dann, wenn ein Abfall des Potentials am Verbindungspunkt (P) auf das Referenzpotential (RP) detektiert wird, nicht-leitend gesteuert wird, wobei das Referenzpotential RP so gewählt wird, daß keine parasitären Elemente der ersten Halbleiterschaltereinrichtung (ST1) und der zweiten Halbleiterschaltereinrichtung (ST2) in den leitenden Zustand gelangen.

2. Halbleiterschaltung nach Anspruch 1,
bei welcher die erste Halbleiterschaltereinrichtung (ST1) durch einen ersten VDMOS-Transistor und die zweite Halbleiterschaltereinrichtung (ST2) durch einen zweiten VDMOS-Transistor gebildet sind und die ersten Hauptstreckenelektroden durch deren Drainelektroden (D1, D2), die zweiten Hauptstreckenelektroden durch deren Sourceelektroden (S1, S2) und die Steuerelektroden durch deren Gateelektroden (G1, G2) gebildet sind.

3. Halbleiterschaltung nach Anspruch 2,
bei welcher die beiden VDMOS-Transistoren (ST1, ST2) je durch einen P-Kanal-VDMOS-Transistor gebildet sind,
das Versorgungsspannungspotential bezüglich des Bezugspotentials positiv ist, und
die parasitären Substratdioden (SD) leiten würden, wenn sich die Drainelektrode (D1, D2) des zugehörigen VDMOS-Transistors (ST1, ST2) auf einem Potential befände, das um mindestens die Einschaltschwellenspannung der Substratdiode (SD) unterhalb des momentanen Bezugspotentials liegt.

4. Halbleiterschaltung nach Anspruch 1,
bei welcher die erste Halbleiterschaltereinrichtung (ST1) durch einen ersten NPN-Transistor und die zweite Halbleiterschaltereinrichtung (ST2) durch einen zweiten NPN-Transistor gebildet ist und die ersten Hauptstreckenelektroden durch deren Kollektoren, die zweiten Hauptstreckenelektroden durch deren Emitter und die Steuerelektroden durch deren Basiselektroden gebildet sind.

5. Halbleiterschaltung nach einem der Ansprüche 1 bis 4,
bei welcher der Ausgangsanschluß (OUT) einen Busleitungsanschluß bildet.

6. Halbleiterschaltung nach einem der Ansprüche 1 bis 5,
bei welcher die Schwellenwertdetektorschaltung (COM) eine mit einem invertierenden Eingang (-) und einem nicht-invertierenden Eingang (+) versehene Komparatorschaltung (COM) aufweist, deren invertierender Eingang (-) mit dem Referenzpotential (RP), deren nicht-invertierender Eingang (+) mit dem Verbindungspunkt (P) und deren Ausgang mit der Verknüpfungsschaltung (NAND) gekoppelt ist.

7. Halbleiterschaltung nach Anspruch 6,
bei welcher als Verknüpfungsschaltung (NAND) eine zwei Eingänge (A, B) und einen Ausgang aufweisende NAND-Verknüpfungsschaltung vorgesehen ist,
deren einer Eingang (B) mit dem Ausgang der Komparatorschaltung (COM) und deren anderer Eingang (A) mit einem Eingangsanschluß (IN) der Halbleiterschaltung verbunden ist, der für die Zuführung eines Schaltsteuersignals für die erste Halbleiterschaltereinrichtung (ST1) vorgesehen ist, und deren Ausgang mit dem Steuereingang (G3) der dritten Halbleiterschaltereinrichtung (ST3) verbunden ist.

8. Halbleiterschaltung nach einem der Ansprüche 1 bis 7,
bei welcher die dritte Halbleiterschaltereinrichtung (ST3) durch einen MOS-Transistor gebildet ist, dessen Source (S3) mit dem Versorgungsspannungsanschluß (Vs), dessen Drain (D3) mit dem Steueranschluß (G2) der zweiten Halbleiterschaltereinrichtung (ST2) und dessen Gate (G3) mit dem Ausgang der NAND-Verknüpfungsschaltung gekoppelt ist.

9. Halbleiterschaltung nach einem der Ansprüche 4 bis 7,
bei welcher die dritte Halbleiterschaltereinrichtung (ST3) durch einen NPN-Transistor gebildet ist, dessen Kollektor mit dem Versorgungsspannungsanschluß (Vs), dessen Emitter mit dem Steueranschluß (G2) der zweiten Halbleiterschaltereinrichtung (ST2) und dessen Basis mit dem Ausgang der NAND-Verknüpfungsschaltung gekoppelt ist.

10. Halbleiterschaltung nach Anspruch 8 oder 9,
bei welcher die Source (S3) bzw. der Kollektor des MOS-Transistors (ST3) bzw. des NPN-Transistors mit der Kathodenseite einer anodenseitig mit dem Versorgungsspannungsanschluß (Vs) verbundenen Diode (D2) gekoppelt ist.

## Claims

1. An integrated semiconductor circuit comprising
a) a supply voltage terminal (Vs), a ground terminal (GND) for connection to a reference potential, and an output terminal (OUT);
b) a substrate (11) connected to said ground terminal (GND) ;
c) a series connection provided between said output terminal (OUT) and said ground terminal (GND) and including a controllable first semiconductor switch means (ST1) located on the ground terminal side and a controllable second semiconductor switch means (ST2) located on the output terminal side, said semiconductor switch means each having a first main path electrode (D1, D2), a second main path electrode (S1, S2) and a control electrode (G1, G2) and each containing a parasitic substrate diode (SD) which is located between the first main path electrode and the substrate;
d) the first main path electrodes (D1, D2) of the two semiconductor switch means (ST1, ST2) being coupled to each other, the second main path electrode (S1) of the first semiconductor switch means (ST1) being coupled to the ground terminal (GND) and the second main path electrode (S2) of the second semiconductor switch means (ST2) being coupled to the output terminal (OUT);
e) an electrical resistor (R) interconnecting the control electrode (G2) and the second main path electrode (S2) of the second semiconductor switch means (ST2);
f) a third semiconductor switch means (ST3) provided with a control terminal (G3), which has its main path (S-D) connected between the supply voltage terminal (Vs) and the control terminal (G2) of the second semiconductor switch means (ST2) and, in the conducting switching state, passes a current through the resistor (R) that effects at said resistor (R) a voltage drop switching the second semiconductor switch means (ST2) to the conducting state;
g) a threshold detector circuit (COM) for detecting the dropping of the potential at the connecting node (P) between said first and second semiconductor switch means (ST1, ST2) to a reference potential (RP); and
h) a gate circuit (NAND) connected between the threshold detector circuit (COM) and the control terminal of the third semiconductor switch means (ST3), by means of which the third semiconductor switch means (ST3), both when the first semiconductor switch means (ST1) is in the non-conducting state and when the first semiconductor switch means (ST1) is in the conducting state, is switched to the non-conducting state if a drop of the potential at the connecting node (P) to the reference potential (RP) is detected, with the reference potential (RP) being selected such that no parasitic devices of the first semiconductor switch means (ST1) and of the second semiconductor switch means (ST2) reach the conducting state.

2. A semiconductor circuit according to claim 1,
wherein said first semiconductor switch means (ST1) is constituted by a first VDMOS transistor and the second semiconductor switch means (ST2) is constituted by a second VDMOS transistor, and the first main path electrodes are constituted by the drain electrodes (D1, D2) thereof, the second main path electrodes by the source electrodes (S1, S2) thereof and the control electrodes by the gate electrodes (G1, G2) thereof.

3. A semiconductor circuit according to claim 2,
wherein the two VDMOS transistors (ST1, ST2) are each constituted by a P-channel VDMOS transistor,
the supply voltage potential is positive with respect to the reference potential, and
the parasitic substrate diodes (SD) will be conducting if the drain electrode (D1, D2) of the associated VDMOS transistor (ST1, ST2) is at a potential that is lower than the instantaneous reference potential at least by the switching-on threshold voltage of the substrate diode (SD).

4. A semiconductor circuit according to claim 1,
wherein the first semiconductor switch means (ST1) is constituted by a first NPN transistor and the second semiconductor switch means (ST2) by a second NPN transistor, and the first main path electrodes are constituted by the collectors thereof, the second main path electrodes by the emitters thereof and the control electrodes by the base electrodes thereof.

5. A semiconductor circuit according to any of claims 1 to 4,
wherein the output terminal (OUT) constitutes a bus line terminal.

6. A semiconductor circuit according to any of claims 1 to 5,
wherein the threshold detector circuit (COM) comprises a comparator circuit (COM) provided with an inverting input (-) and a non-inverting input (+) and having its inverting input (-) connected to the reference potential (RP), its non-inverting input (+) to the connecting node (P) and its output to the gate circuit (NAND).

7. A semiconductor circuit according to claim 6,
wherein the gate circuit (NAND) is constituted by a NAND gate circuit having two inputs (A, B) and one output, the one input (B) thereof being connected to the output of the comparator circuit (COM) and the other input (A) thereof being connected to the input terminal (IN) of the semiconductor circuit that is provided for being fed with a switching control signal for the first semiconductor switch means (ST1), and the output thereof being connected to the control input (G3) of the third semiconductor switch means (ST3).

8. A semiconductor circuit according to any of claims 1 to 7,
wherein the third semiconductor switch means (ST3) is constituted by MOS transistor having its source (S3) connected to the supply voltage terminal (Vs), its drain (D3) to the control terminal (G2) of the second semiconductor switch means (ST2) and its gate (G3) to the output of the NAND gate circuit.

9. A semiconductor circuit according to any of claims 4 to 7,
wherein the third semiconductor switch means (ST3) is constituted by an NPN transistor having its collector connected to the supply voltage terminal (Vs), its emitter to the control terminal (G2) of the second semiconductor switch means (ST2) and its base to the output of the NAND gate circuit.

10. A semiconductor circuit according to claim 8 or 9,
characterized in that the source (S3) of the MOS transistor (ST3) or the collector of the NPN transistor, respectively, is coupled to the cathode side of a diode (D2) having its anode side connected to the supply voltage terminal (Vs).

## Revendications

1. Circuit intégré à semiconducteur comprenant :
a) une borne de tension d'alimentation (Vs), une borne de masse (GND) pour liaison à un potentiel de masse et une borne de sortie (OUT) ;
b) un substrat (11) lié à la borne de masse (GND) ;
c) un circuit série disposé entre la borne de sortie (OUT) et la borne de masse (GND) comprenant un premier dispositif commutateur à semiconducteur (ST1) commandable, disposé du côté de la borne de masse, et un deuxième dispositif commutateur à semiconducteur (ST2) commandable, disposé du côté de la borne de sortie, chaque dispositif commutateur à semiconducteur comportant une première électrode principale (D1, D2), une deuxième électrode principale (S1, S2) et une électrode de commande (G1, G2), et chaque dispositif commutateur à semiconducteur présentant une diode parasite de substrat (SD), située entre la première électrode principale et le substrat ;
d) dans lequel les premières électrodes principales (D1, D2) des deux dispositifs commutateurs à semiconducteur (ST1, ST2) sont couplées, dans lequel la deuxième électrode principale (S1) du premier dispositif commutateur à semiconducteur (ST1) est couplée à la borne de masse (GND) et dans lequel la deuxième électrode principale (S2) du deuxième dispositif commutateur à semiconducteur (ST2) est couplé à la borne de sortie (OUT) ;
e) une résistance électrique (R) reliant l'électrode de commande (G2) et la deuxième électrode principale (S2) du deuxième dispositif commutateur à semiconducteur (ST2) ;
f) un troisième dispositif commutateur à semiconducteur (ST3) comportant une borne de commande (G3) et une voie principale de conduction (S-D), couplée entre la borne de tension d'alimentation (Vs) et la borne de commande (G2) du deuxième dispositif commutateur à semiconducteur (ST2) et permettant, à l'état conducteur, le passage d'un courant dans la résistance (R), ce courant produisant, aux bornes de la résistance (R) , une chute de tension faisant passer le deuxième dispositif commutateur à semiconducteur (ST2) à l'état passant ;
g) un circuit de détection de seuil (COM), au moyen duquel la baisse de potentiel au point de liaison (P) situé entre les premier et deuxième dispositifs commutateurs à semiconducteur (ST1, ST2) est détectée par rapport à un potentiel de référence (RP) ; et
h) un circuit logique (NAND) connecté entre le. circuit de détection de seuil (COM) et la borne de commande du troisième dispositif commutateur à semiconducteur (ST3), le circuit logique faisant passer le troisième dispositif commutateur à semiconducteur (ST3) à l'état non passant, lorsque le premier dispositif commutateur à semiconducteur (ST1) est à l'état non passant et, quand le premier dispositif commutateur à semiconducteur (ST1) est à l'état passant, lorsqu'une baisse du potentiel du point de liaison (P) est détectée par rapport au potentiel de référence (RP),
dans lequel le potentiel de référence (RP) est choisi de sorte qu'aucun élément parasite du premier dispositif commutateur à semiconducteur (ST1) et du deuxième dispositif commutateur à semiconducteur (ST2) ne parvienne à l'état passant.

2. Circuit à semiconducteur selon la revendication 1, dans lequel le premier dispositif commutateur à semiconducteur (ST1) est formé d'un premier transistor VDMOS et le deuxième dispositif commutateur à semiconducteur (ST2) est formé d'un deuxième transistor VDMOS, et dans lequel les premières électrodes principales sont formées par les électrodes de drain (D1, D2) des transistors VDMOS, les deuxièmes électrodes principales sont formées par leurs électrodes de source (S1, S2) et les électrodes de commande par leurs électrodes de grille (G1, G2).

3. Circuit à semiconducteur selon la revendication 2, dans lequel les deux transistors VDMOS (ST1, ST2) sont formés chacun d'un transistor VDMOS à canal P, dans lequel le potentiel de tension d'alimentation est positif par rapport au potentiel de masse et dans lequel les diodes parasites de substrat (SD) conduiraient, si l'électrode de drain (D1, D2) du transistor VDMOS correspondant (ST1, ST2) se trouvait à un potentiel inférieur au potentiel de masse instantané d'au moins la tension de seuil de la diode de substrat (SD).

4. Circuit à semiconducteur selon la revendication 1, dans lequel le premier dispositif commutateur à semiconducteur (ST1) est formé d'un premier transistor NPN et le deuxième dispositif commutateur à semiconducteur (ST2) est formé d'un deuxième transistor NPN, et dans lequel les premières électrodes principales sont formées par les collecteurs des transistors NPN, les deuxièmes électrodes principales par leurs émetteurs, et les électrodes de commande par leurs électrodes de base.

5. Circuit à semiconducteur selon une des revendications 1 à 4, dans lequel la borne de sortie (OUT) constitue une borne de liaison à un bus.

6. Circuit à semiconducteur selon une des revendications 1 à 5, dans lequel le circuit de détection de seuil (COM) comporte un circuit comparateur (COM) présentant une entrée inverseuse (-) et une entrée non inverseuse (+), l'entrée non inverseuse (-) étant couplée au potentiel de référence (RP), l'entrée non inverseuse (+) étant couplée au point de liaison (P), et dans lequel la sortie du circuit comparateur est couplée au circuit logique NAND.

7. Circuit à semiconducteur selon la revendication 6, dans lequel le circuit logique (NAND) est un circuit logique NAND présentant deux entrées (A, B), une entrée (B) étant reliée à la sortie du circuit comparateur (COM) et l'autre entrée (A) étant reliée à une borne d'entrée (IN) du circuit à semiconducteur, prévue pour conduire un signal de commande de commutation du premier dispositif commutateur à semiconducteur (ST1), la sortie du circuit logique NAND étant reliée à l'entrée de commande (G3) du troisième dispositif commutateur à semiconducteur (ST3).

8. Circuit à semiconducteur selon l'une des revendications 1 à 7, dans lequel le troisième dispositif commutateur à semiconducteur (ST3) est formé d'un transistor MOS, dont la source (S3) est couplée à la borne de tension d'alimentation (Vs), dont le drain (D3) est couplé à la borne de commande (G2) du deuxième dispositif commutateur à semiconducteur (ST2) et dont la grille (G3) est cauplêe à la sortie du circuit logique (NAND).

9. Circuit à semiconducteur selon l'une des revendications 4 à 7, dans lequel le troisième dispositif commutateur à semiconducteur (ST3) est formé d'un transistor NPN, dont le collecteur est couplé à la borne de tension d'alimentation (Vs), dont l'émetteur est couplé à la borne de commande (G2) du deuxième dispositif commutateur à semiconducteur (ST2) et dont la base est couplée à la sortie du circuit logique (NAND).

10. Circuit à semiconducteur selon la revendication 8 ou 9, dans lequel la source (S3) du transistor MOS (ST3), respectivement le collecteur du transistor NPN, est couplé à la cathode d'une diode (D2) reliée par l'anode à la borne de tension d'alimentation (Vs).
